(19) Europäisches Patentamt
European Patent Office
Office européen des brevets

(11) EP 2 014 697 B1

(12) **EUROPEAN PATENT SPECIFICATION**

(45) Date of publication and mention of the grant of the patent:
**14.12.2011 Bulletin 2011/50**

(51) Int Cl.:
***C08G 73/10*** *(2006.01)* ***H01L 33/56*** *(2010.01)*

(21) Application number: **08012127.0**

(22) Date of filing: **04.07.2008**

(54) **Resin for optical semiconductor element encapsulation containing polyimide**

Harz für die optische Halbleiterelementkapselung mit Polyimid

Résine pour encapsulation d'élément de semi-conducteur optique contenant du polyimide

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **11.07.2007 JP 2007182487**

(43) Date of publication of application:
**14.01.2009 Bulletin 2009/03**

(73) Proprietor: **Nitto Denko Corporation**
**Ibaraki-shi**
**Osaka 567-8680 (JP)**

(72) Inventors:
- **Katayama, Hiroyuki**
  **Ibaraki-shi**
  **Osaka 567-8680 (JP)**
- **Harada, Noriaki**
  **Ibaraki-shi**
  **Osaka 567-8680 (JP)**

(74) Representative: **Grünecker, Kinkeldey, Stockmair & Schwanhäusser**
**Leopoldstrasse 4**
**80802 München (DE)**

(56) References cited:
**EP-A- 0 311 374** **EP-A- 0 323 644**
**EP-A- 0 424 940** **EP-A- 1 146 063**
**EP-A- 1 329 769** **EP-A- 1 431 822**
**EP-A- 2 009 058** **US-A- 6 047 098**
**US-A1- 2004 266 979**

- **QINGHUA LI ET AL: "ABSORPTION FLUORESCENCE AND THERMAL PROPERTIES OF TRANSPARENT POLYIMIDES BASED ON CYCLOBUTANETETRACARBOXYLIC DIANHYDRIDE" POLYMER JOURNAL, SOCIETY OF POLYMER SCIENCE, TOKYO, JP, vol. 30, no. 10, 1 January 1998 (1998-01-01), pages 805-812, XP002927597 ISSN: 0032-3896**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 014 697 B1

## Description

The present invention relates to a resin for optical semiconductor element encapsulation containing a polyimide; and to an optical semiconductor device encapsulated with the resin.

Recently, with the increasing use of a larger electric current owing to the improvement in emission efficiency and luminous flux of a light-emitting diode (LED), there arises a problem of deterioration of an LED-encapsulating resin, which causes a shortened operating life of LED. In general, as the LED-encapsulating resin, an epoxy resin is frequently used. However, it is known that when a high-output blue or white LED, which has currently attracted attention in the lighting industry, is irradiated with short-wavelength (e.g., 350 to 500 nm) light having a large energy and injection current density is increased to result in increased heat generation, the deterioration of the epoxy resin occurs more severely. Thus, for the purpose of improving transparency, light resistance, and heat resistance of the resin, there has been reported a resin containing an alicyclic epoxy compound (see JP-A-7-309927) and an epoxy resin modified with a silicone (see JP-A-2006-274249).

Furthermore, since a polyimide has extremely high heat resistance in comparison with an epoxy resin, there has been proposed a technology where a polyimide is used for encapsulation of an LED element. For example, in JP-A-63-7657, since a polyimide obtained by reacting a specific aromatic acid dianhydride with a specific aromatic diamine compound is colorless and transparent and has an extremely high transparency, it is reported that the polyimide can suppress decrease in transmittance of light and improve light-emitting efficiency. In JP-A-2001-102500, it is disclosed that a polyimide film having a low elastic modulus and capable of being easily processed can be obtained by combined use of a siloxane compound in a general reaction of a polyimide. Moreover, in JP-A-2002-322275 , in the reaction of raw materials such as an acid dianhydride and a diamine, it is reported that a polyimide is rapidly obtained without producing any by-product by using a silylamide-based silylating agent.

However, a resin containing an alicyclic epoxy compound and an epoxy resin modified with a silicone still have an insufficient heat resistance as a resin for blue or white LED encapsulation. Moreover, a polyimide (wholly aromatic polyimide) obtained by reacting an aromatic acid dianhydride with an aromatic diamine has a problem of lowered durability against short-wavelength light. This is because the presence of the aromatic groups constituting the main chain of the polyimide increases absorption of the short-wavelength light to thereby accelerate photodegradation of the resin.

EP-A-1146063 discloses specific polyimide precursors. The polyimide is obtained by polycondensation of a tetracarboxylic dianhydride with an aliphatic or aromatic diamine.

US-A-6047098 discloses a plastic optical waveguide constructed with a polyimide obtained from an acid dianhydric-based component and a diamine-based component.

EP-A-1329769 relates to a positive photosensitive resin composition comprising a solvent-soluble polyimide obtained by polycondensation of an acid dianhydride with an aliphatic or aromatic diamine compound.

US-A-2004/0266979 relates to a solvent-soluble polyimide produced by polycondensing at least one tetracarboxylic acid component with at least one diamine component in the presence of a tertiary amine.

EP-A-0323644 discloses polyimide resins having a repeating unit derived from a tetravalent organic group constituting a tetracarboxylic acid or its derivative, and a bivalent organic group constituting a diamine).

EP-A-1431822 relates to specific polyimides, comprising a tetravalent organic group derived from alicyclic tetracarboxylic dianhydride and a divalent organic group derived from a diamine.

EP-A-0311374 relates to a polyimide obtained from a polyamide-acid or polyamide-acid ester prepared by reacting the cyclohexyl tetracarboxylic ester or anhydride with a diamine.

EP-A-0424940 discloses a positive photosensitive polyimide resin composition.

Q.Li et al., "Absorption Fluorescence and Thermal Properties of Transparent Polyimides Based on Cyclobutanetetracarboxylic Dianhydride", Polymer Journal, Vol.30, No.10, January 1, 1998, pp 805 to 812, relates to the absorption, fluorescence and thermal properties of transparent polyimide based on cyclobutane tetracarboxylic dianhydride.

EP-A-2009058 discloses a thermosetting polyimide resin obtained by mixing a tetracarboxylic acid component with an aromatic diamine.

An object of the invention is to provide a resin for optical semiconductor element encapsulation containing a polyimide, which has a high light-transmitting property, is excellent in heat resistance, and shows an excellent light resistance even against short-wavelength light, and a photo semiconductor device encapsulated with the resin.

As a result of extensive studies for achieving the above object, the present inventors found that a polyimide (wholly aliphatic polyimide) obtained by an imidation of a reaction product of an aliphatic acid dianhydride with an aliphatic diamine compound and a polyimide (semi-aliphatic polyimide) obtained by an imidation of a reaction product of an aliphatic acid dianhydride with an aromatic diamine have a high light-transmitting property and are excellent in heat resistance, as well as they are excellent in light resistance against short-wavelength light and shows excellent durability as a resin for LED encapsulation as compared with a polyimide (wholly aromatic polyimide) obtained by an imidation of a reaction product of an aromatic acid dianhydride with an aromatic diamine. Thus, they have accomplished the invention.

The present invention provides a resin for optical semiconductor element encapsulation comprising a polyimide

which is obtained by an imidation of a polyimide precursor obtained by a polycondensation of an aliphatic acid dianhydride with an aliphatic diamine compound selected from the group consisting of the compounds represented by the following formulae (X) to (XI):

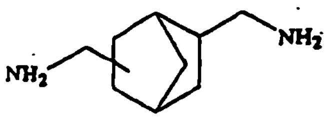

(X)

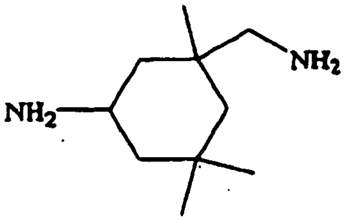

(XI)

The present invention further provides an optical semiconductor device comprising the above resin and an optical semiconductor element encapsulated with the resin.

Preferred embodiments are set forth in the subclaims.

The resin for optical semiconductor element encapsulation according to the present invention exhibits excellent advantages that it has a high light-transmitting property, is excellent in heat resistance, and shows an excellent light resistance even against short-wavelength light. Accordingly, the optical semiconductor device encapsulated using the resin can achieve a long operating life even when it is a device having a blue or white LED element mounted thereon.

The resin for optical semiconductor element encapsulation containing the polyimide according to the invention is suitably used for encapsulation of semiconductor elements of a backlight for a liquid crystal screen, a traffic signal, an outdoor large display, an advertising display, and the like.

The resin for optical semiconductor element encapsulation according to the present invention contains a polyimide which is obtained by an imidation of a polyimide precursor obtained by a polycondensation of an aliphatic acid dianhydride with an aliphatic or aromatic diamine compound. In the present specification, the polyimide precursor obtained by reacting an aliphatic acid dianhydride with an aliphatic diamine compound is referred to as a wholly aliphatic polyimide precursor, the polyimide precursor obtained by reacting an aliphatic acid dianhydride with an aromatic diamine compound is referred to as a semi-aliphatic polyimide precursor, and the polyimide precursor obtained by reacting an aromatic acid dianhydride with an aromatic diamine compound is referred to as a wholly aromatic polyimide precursor.

As the aliphatic acid dianhydride, there may be mentioned aliphatic acid dianhydrides the same as those hitherto used in the production of polyimides or polyimide precursors. Among these, from the viewpoints of transparency, heat resistance, light resistance, and versatility, tetracarboxylic dianhydrides represented by the following formulae (I) to (VII):

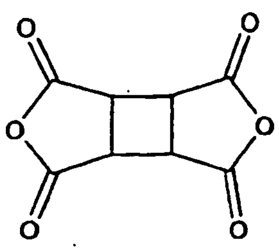

(I)

,

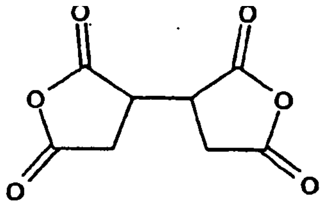

(II)

,

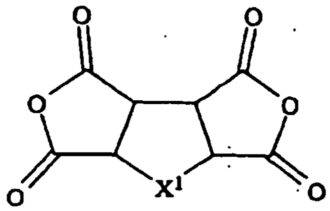

(III)

,

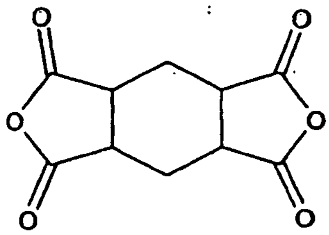

(IV)

,

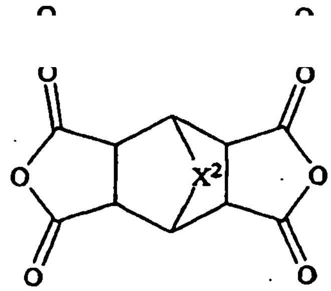

(V)

,

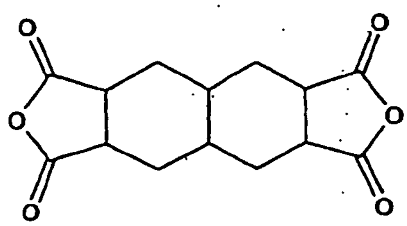

(VI)

, and

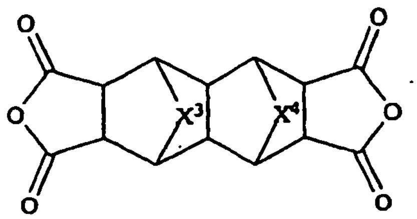

(VII)

wherein $X^1$ represents O, S, $CH_2$, $C(CH_3)_2$, or $C(CF_3)_2$;

$X^2$ represents O, S, or $CH_2$; and
$X^3$ and $X^4$ each independently represent O, S, or $CH_2$, are preferred.

The above-mentioned tetracarboxylic acid dianhydrides can be used singly or as a combination of two or more thereof. Of these, in the invention, 1,2,3,4-cyclobutanetetracarboxylic dianhydride represented by the formula (I), 1,2,3,4-butanetetracarboxylic dianhydride represented by the formula (II), and 1,2,3,4-cyclopentanetetracarboxylic dianhydride of the formula (III) in which $X^1$ is $CH_2$ are more preferred.

Moreover, the resin for encapsulation of the invention may contain an acid dianhydride other than the tetracarboxylic acid dianhydrides represented by the above formulae (I) to (VII) within a range where the advantages of the invention are not impaired. For obtaining high light-transmitting property and light resistance which are purposes of the invention, total content of the tetracarboxylic acid dianhydrides represented by the formulae (I) to (VII) in the acid dianhydrides subjected to the reaction is preferably 80% by weight or more, more preferably 90% by weight or more, further preferably 95% by weight or more, and a content of substantially 100% by weight is still further preferred.

The aliphatic diamine compounds are represented by the following formulae (X) to (XI):

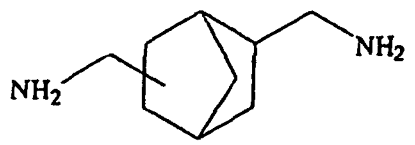

(X)

and

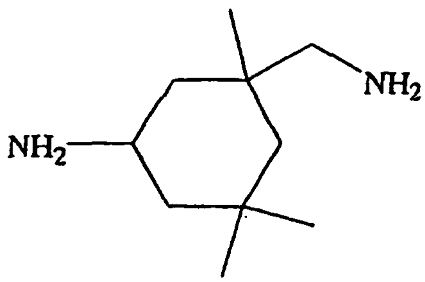

(XI)

Moreover, the resin for encapsulation of the invention may contain a diamine compound other than the aliphatic diamine compounds represented by the above formulae (X) to (XI) within a range where the advantages of the invention are not impaired. For obtaining high light transparency and light resistance which are purposes of the invention, total content of the aliphatic diamine compounds represented by the above formulae (X) to (XI) in the diamine compounds subjected to the reaction is preferably 80% by weight or more, more preferably 90% by weight or more, further preferably 95% by weight or more, and a content of substantially 100% by weight is still further preferred.

In the case of synthesizing the wholly aliphatic polyimide precursor in the invention, the aliphatic diamine compound is first silylated with a silylating agent such as N,O-bis(trimethylsilyl)trifluoroacetamide or N,O-bis(trimethylsilyl) acetamide at a temperature of 0 to 40°C in an organic solvent under an inert gas atmosphere and then the aliphatic acid dianhydride is reacted at a temperature of 20 to 150°C. Moreover, in the case of synthesizing the semi-aliphatic polyimide precursor, the aromatic diamine compound and the aliphatic acid dianhydride may be subjected to a polycondensation at a temperature of 20 to 150°C in an organic solvent under an inert gas atmosphere. In this connection, any precursor is obtained as a solution of the organic solvent used in the reaction.

As the organic solvent, there may be mentioned N,N-dimethylformamide, N,N-dimethylacetamide, N-methyl-2-pyrrolidone, N-methylcaprolactam, dimethyl sulfoxide, pyridine, tetrahydrofuran, cyclohexanone, 1,4-dioxane, and the like. They can be used singly or as a combination of two or more thereof.

The ratio (acid dianhydrides/diamine compounds) of total molar amount of the tetracarboxylic acid dianhydrides represented by the formulae (I) to (VII) to total molar amount of the aliphatic diamine compounds represented by the above formulae (X) to (XI) is preferably 1.5/1.0 to 1.0/1.5, more preferably 1.1/1.0 to 1.0/1.1, from the viewpoint of formation of a higher-molecular-weight product.

The molecular weight of the polyimide precursor is preferably 1,000 to 100,000, more preferably 5,000 to 100,000. In the present specification, the molecular weight of the polyimide precursor is measured by gel permeation chromatography (GPC).

In the case where the polyimide precursor is transformed into a solution for application, the viscosity of a solution

containing 15 to 30% by weight of the polyimide precursor at 25°C is preferably 200 to 50,000 mPa·s, more preferably 500 to 30,000 mPa·s. In the present specification, the viscosity is measured in accordance with the method described in Examples to be mentioned below.

The resultant polyimide precursor is imidated as it is or in a sheet state. In the specification, the polyimide obtained by imidating the wholly aliphatic polyimide precursor is referred to as a wholly aliphatic polyimide, the polyimide obtained by imidating the semi-aliphatic polyimide precursor is referred to as a semi-aliphatic polyimide, and the polyimide obtained by imidating the wholly aromatic polyimide precursor is referred to as a wholly aromatic polyimide.

As the imidation reaction, there may be mentioned an imidation reaction by heating, an imidation reaction by a chemical reaction, and the like and, in the invention, it is preferred to carry out the imidation reaction by heating. The heating reaction is carried out in a temperature range of preferably 50 to 400°C, more preferably 100 to 300°C and may be carried out continuously and may be carried out under reduced pressure or in an inert gas atmosphere. In the invention, from the viewpoint of securing transparency, a resin containing the polyimide can be obtained by carrying out the reaction continuously at 100°C for 1 hour, at 150°C for 1 hour, at 200°C for 3 hours, and at 240°C for 3 hours under reduced pressure (preferably 0.001 to 4 kPa).

In the case where the polyimide precursor is imidated in a sheet state, the resin can be formed into a sheet shape, for example, by optionally diluting a solution of the above polyimide precursor with an organic solvent such as N,N-dimethylacetamide or N-methyl-2-pyrrolidone, and subsequently applying the solution on a releasing sheet (e.g., a polyester film) having a surface treated with a silicone, a glass substrate, or the like in an appropriate thickness by a method such as casting, spin coating, or roll coating, followed by the above imidation reaction by heating.

Since the resin containing the polyimide has a high light-transmitting property, for example, in the case that the resin is formed into a sheet shape having a thickness of 10 to 500 μm, transmittance for an incident light having a wavelength of 400 to 700 nm is preferably 90% or more, more preferably 95% or more, further preferably 98 to 100%. Moreover, transmittance for an incident light having a wavelength of 380 nm is preferably 90% or more, more preferably 95% or more, further preferably 98 to 100%. In the present specification, the light-transmitting property is measured in accordance with the method described in Examples to be mentioned below.

Moreover, 5% weight-loss temperature of the resin containing the polyimide is preferably 250°C or higher, more preferably 300°C or higher from the viewpoint of heat resistance. In the present specification, the 5% weight-loss temperature is measured in accordance with the method described in Examples to be mentioned below.

Since the thus obtained resin containing the polyimide not only has a high light-transmitting property and is excellent in heat resistance but also shows excellent light resistance even against short-wavelength light, it may be suitably used as a resin for optical semiconductor element encapsulation to be used, for example, in optical semiconductor devices (a backlight for a liquid crystal screen, a traffic signal, an outdoor large display, an advertising display, and the like) having a blue or white LED element mounted thereon. Therefore, the invention also provides an optical semiconductor device including the above-mentioned resin for optical semiconductor element encapsulation and an optical semiconductor element encapsulated with the resin.

The optical semiconductor device of the invention can be produced by encapsulating an LED element using, as the resin for optical semiconductor element encapsulation according to the invention, the polyimide precursor before an imidation or the polyimide obtained by an imidation of the polyimide precursor. Specifically, in the case of using the polyimide precursor, the optical semiconductor device can be produced by applying the polyimide precursor as it is in an appropriate thickness on a substrate having an LED element mounted thereon by a method such as casting, spin coating, or roll coating, followed by heating and drying. Moreover, in the case of using the polyimide, the optical semiconductor device can be produced by laminating a sheet containing the polyimide, which is formed in an appropriate thickness by a method such as casting, spin coating, or roll coating, on a substrate having an LED element mounted thereon, followed by bonding the sheets by means of a laminator or the like.

Since the optical semiconductor device of the invention contains the resin of the invention containing the polyimide having a high light-transmitting property and excellent in heat resistance and light resistance as a resin for optical semiconductor element encapsulation, the deterioration of the resin does not generate even when it is an optical semiconductor device having a blue or white LED element mounted thereon and the device can be maintained in a high emission luminance state for a long period of time, so that it can be suitably used.

## Examples

### Viscosity of Polyimide Precursor

Using a viscometer (DV-1+, manufactured by Brookfield), a resultant solution of a polyimide precursor was used as it was or optionally diluted with an organic solvent such as N,N-dimethylacetamide or N-methyl-2-pyrrolidone and then the viscosity of the solution having a polyimide precursor concentration of 15 to 30% by weight was measured.

Light-Transmitting Property of Polyimide

Using a spectrophotometer (U-4100, manufactured by Hitachi High-Technologies Corporation), the transmittance for an incident light having 380 nm or 400 nm was measured.

5% Weight-Loss Temperature of Polyimide

Using a thermogravimetric/differential thermal analyzer (TG/DTA300, manufactured by Seiko), 5% weight-loss temperature under a nitrogen stream was determined.

Illustrative Example 1 (Polyimide Precursor A) (outside the scope of the claims)

To 15 mL of N-methyl-2-pyrrolidone was added 3.29 g (0.0156 mol) of 4,4-methylenebis(cyclohexylamine), followed by dissolution at 0°C under a nitrogen atmosphere. Thereto was added 4.2 mL of N,O-bis(trimethylsilyl)trifluoroacetamide, followed by stirring and mixing at 0°C for 15 minutes and further at room temperature (25°C) for 30 minutes. The resultant colorless transparent solution was again cooled to 0°C and 3.10 g (0.0157 mol) of 1,2,3,4-butanetetracarboxylic dianhydride was added. After mixing at 0°C for 1 hour, the whole was stirred and reacted at 25°C for 14 hours to obtain a solution of a polyimide precursor A (wholly aliphatic polyimide precursor, molecular weight: 21,900). Table 1 shows physical properties of the resultant polyimide precursor solution.

Moreover, the resultant polyimide precursor A solution was applied on a glass plate using an applicator so that the thickness was 50 μm. Under reduced pressure (1 kPa), the solution was dried and cured by continuous heating at 100°C for 1 hour, at 150°C for 1 hour, at 200°C for 3 hours, and at 240°C for 3 hours to thereby obtain a sheet containing the polyimide A. Table 1 shows physical properties of the resultant polyimide sheet. In this connection, at the application on the glass plate, the polyimide precursor A solution was used after dilution by adding 11 mL of N-methyl-2-pyrrolidone and 38 mL of N,N-dimethylacetamide.

Example 2 (Polyimide Precursor B)

To 22 mL of N,N-dimethylacetamide was added 2.32 g (0.0151 mol) of 2,5(2,6)-bis(aminomethyl)bicyclo[2.2.1]heptane, followed by dissolution at 0°C under a nitrogen atmosphere. Thereto was added 4.1 mL of N, O-bis(trimethylsilyl)trifluoroacetamide, followed by stirring at 0°C for 15 minutes and further at room temperature (25°C) for 30 minutes. The resultant colorless transparent solution was again cooled to 0°C and 2.99 g (0.0151 mol) of 1,2,3,4-butanetetracarboxylic dianhydride was added. After mixing at 0°C for 1 hour, the whole was stirred and reacted at 25°C for 21 hours to obtain a solution of a polyimide precursor B (wholly aliphatic polyimide precursor, molecular weight: 36,300). Table 1 shows physical properties of the resultant polyimide precursor solution.

Moreover, a sheet containing the polyimide B was obtained in the same manner as in Example 1 except that the polyimide precursor B solution was used as it was without dilution, instead of the polyimide precursor A solution. Table 1 shows physical properties of the resultant polyimide sheet.

Example 3 (Polyimide Precursor C)

To 20 mL of N,N-dimethylacetamide was added 2.28 g (0.0200 mol) of 1,4-cyclohexanediamine, followed by dissolution at 0°C under a nitrogen atmosphere. Thereto was added 5.5 mL of N,O-bis(trimethylsilyl)acetamide, followed by stirring at 0°C for 15 minutes and further at room temperature (25°C) for 30 minutes. The resultant colorless transparent solution was again cooled to 0°C and 3.96 g (0.0200 mol) of 1,2,3,4-butanetetracarboxylic dianhydride and 16 mL of N, N-dimethylacetamide were added. After mixing at 0°C for 1 hour, the whole was stirred and reacted at 25°C for 18 hours to obtain a solution of a polyimide precursor C (wholly aliphatic polyimide precursor, molecular weight: 12,500). Table 1 shows physical properties of the resultant polyimide precursor solution.

Moreover, a sheet containing the polyimide C was obtained in the same manner as in Example 1 except that the polyimide precursor C solution was used as it was without dilution, instead of the polyimide precursor A solution. Table 1 shows physical properties of the resultant polyimide sheet.

Example 4 (Polyimide Precursor D)

To 14 mL of N,N-dimethylacetamide was added 1.97 g (0.0128 mol) of 2,5(2,6)-bis(aminomethyl)bicyclo[2.2.1]heptane, followed by dissolution at 0°C under a nitrogen atmosphere. Thereto was added 3.5 mL of N, O-bis(trimethylsilyl)acetamide, followed by stirring at 0°C for 15 minutes and further at room temperature (25°C) for 30 minutes. The resultant colorless transparent solution was again cooled to 0°C and 2.50 g (0.0128 mol) of 1,2,3,4-cyclobutanetetracarboxylic

dianhydride was added. After mixing at 0°C for 1 hour, the whole was stirred and reacted at 25°C for 18 hours to obtain a solution of a polyimide precursor D (wholly aliphatic polyimide precursor, molecular weight: 33,800). Table 1 shows physical properties of the resultant polyimide precursor solution.

Moreover, a sheet containing the polyimide D was obtained in the same manner as in Example 1 except that the polyimide precursor D solution was used as it was without dilution, instead of the polyimide precursor A solution. Table 1 shows physical properties of the resultant polyimide sheet.

Comparative Example 1 (Polyimide Precursor I)

To 18 mL of N,N-dimethylacetamide was added 4.22 g (0.0170 mol) of bis(3-aminophenyl) sulfone, followed by dissolution at 25°C under a nitrogen atmosphere. Thereto was added 5.00 g (0.0170 mol) of 3,3',4,4'-biphenyltetracarboxylic dianhydride and the whole was stirred and reacted at 25°C for 4 days to obtain a solution of a polyimide precursor I (wholly aromatic polyimide precursor, molecular weight: 4,190). Table I shows physical properties of the resultant polyimide precursor solution.

Moreover, a sheet containing the polyimide I was obtained in the same manner as in Example 1 except that the polyimide precursor I solution was used as it was without dilution, instead of the polyimide precursor A solution. Table 1 shows physical properties of the resultant polyimide sheet.

Comparative Example 2 (Epoxy Resin A)

To methyl ethyl ketone were added 45 parts by weight of a bisphenol A-type epoxy resin having an epoxy equivalent of 7500 (Epicoat EP1256, manufactured by Japan Epoxy Resin), 30 parts by weight of an alicyclic epoxy resin having an epoxy equivalent of 260 (EHPE3150, manufactured by Daicel Chemical Industries, Ltd.), 22 parts by weight of 4-methylhexahydrophthalic anhydride (a curing agent, MH-700, manufactured by New Japan Chemical Co., Ltd.), and 1.2 parts by weight of 2-methylimidazole (a curing accelerator, manufactured by Shikoku Chemicals Corporation) so as to achieve a concentration of 50% by weight, and the whole was stirred at 40°C for 1 hour to obtain an epoxy resin A solution for coating.

The resultant epoxy resin A was applied on a glass plate by means of an applicator so as to achieve a thickness of 50 μm. After heated at 150°C for 30 minutes under normal pressure (101.3 kPa), the resin was dried and cured to obtain an epoxy resin sheet A. Table 1 shows physical properties of the resultant epoxy resin sheet.

Illustrative Example 6, Examples 7 to 10 and Comparative Examples 3 to 4

Then, using the resultant resin solutions, optical semiconductor devices were produced. Namely, a solution of each of the polyimide precursors or the epoxy resin was applied on a substrate having an LED element (C455EZ1000, emission spectrum: 420 to 500 nm, manufactured by Cree) mounted thereon so as to achieve a thickness of 50 μm by spin coating (1500 r/min, 20 seconds). The whole was continuously heated at 100°C for 1 hour, at 150°C for 1 hour, at 200°C for 3 hours, and at 240°C for 3 hours under reduced pressure (1 kPa) for the polyimide precursors of Examples 1 to 5 and Comparative Example 1 or was heated at 150°C for 30 minutes under normal pressure (101.3 kPa) for the epoxy resin of Comparative Example 2 and then dried and cured, whereby optical semiconductor devices of Illustrative Example 6, Examples 7 to 10 and Comparative Examples 3 to 4 were obtained. In this connection, as the resin used in Illustrative Example 6, one diluted by adding 11 mL of N-methyl-2-pyrrolidone and 38 mL of N,N-dimethylacetamide to the polyimide precursor A solution was used as a resin for coating.

The properties of the resultant LED devices were investigated according to the method of the following Test Example 1. Table 1 shows the results.

Test Example 1 (Light Resistance)

An electric current of 250 mA was passed through the LED device of each of Examples and Comparative Examples and luminance immediately after the start of the test was measured by an instantaneous multi photometric system (MCPD-3000, manufactured by Otsuka Electronics Co., Ltd.). Thereafter, the device was allowed to stand in the current-flowing state and luminance after the passage of 350 hours was measured in a similar manner. An extinction ratio was calculated according to the following equation to evaluate light resistance. In this connection, those having an extinction ratio of 70% or more were judged to be good.

$$\text{Extinction ratio (\%)} = \{[\text{Luminance immediately after start of test} - \text{Luminance after passage of 350 hours}]/\text{Luminance immediately after start of test}\} \times 100$$

Table 1

| | Resin for encapsu-lation | Precursor physical property | Sheet properties | | | Device property |
|---|---|---|---|---|---|---|
| | | Viscosity (mPa·s) | Transmittance (380 nm) (%) | Transmittance (400 nm) (%) | 5% weight loss temperature (°C) | Extinction ratio (%) |
| Illustrative Example 6 | Polyimide Precursor A (Illustrative Example 1) | 200 | 99.3 | 99.7 | 391 | 103 |
| Example 7 | Polyimide Precursor B (Example 2) | 590 | 99.6 | 99.7 | 392 | 105 |
| Example 8 | Polyimide Precursor C (Example 3) | 3750 | 99.5 | 99.6 | 368 | 111 |
| Example 9 | Polyimide Precursor D (Example 4) | 1900 | 97.6 | 98.3 | 408 | 115 |
| Example 10 | Polyimide Precursor E (Example 5) | 1180 | 98.4 | 99.0 | 293 | 95 |
| Comparative Example 3 | Polyimide Precursor I Comparative Example 1) | 25000 | 1.6 | 70.1 | 333 | 1.3 |
| Comparative Example 4 | Epoxy resin A (Comparative Example 2) | --- | 97.9 | 98.5 | --- | 9.8 |
| * For Comparative Example 4, viscosity of the solution of the epoxy resin (Comparative Example 2) as a precursor and 5% weight-loss temperature were not measured. | | | | | | |

From the above results, it is shown that the LED devices of Examples have high extinction ratios as compared with the LED devices of Comparative Examples and thus are excellent in light resistance. In particular, in Examples 7 to 10 using the wholly aliphatic polyimide precursors, the resin sheets themselves have high light-transmitting property and heat resistance as well as good light resistance against short-wavelength light, so that it is suggested that the influence of light and heat on the polyimide varies to a large extent depending on the amount of aromatic groups constituting the main chain of the polyimide.

## Claims

1. A resin for optical semiconductor element encapsulation comprising a polyimide which is obtained by an imidation of a polyimide precursor obtained by a polycondensation of an aliphatic acid dianhydride with an aliphatic diamine

compound selected from the group consisting of the compounds represented by the following formulae (X) to (XI):

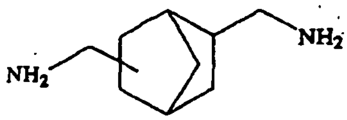

(X)

,

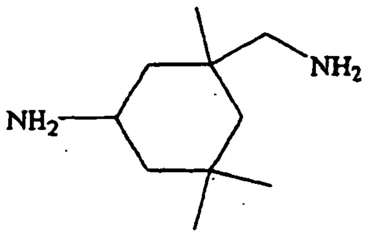

(XI)

2. The resin according to claim 1, wherein the aliphatic acid dianhydride is at least one member selected from the group consisting of the tetracarboxylic acid dianhydrides represented by the following formulae (I) to (VII):

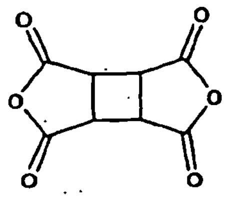

(I)

,

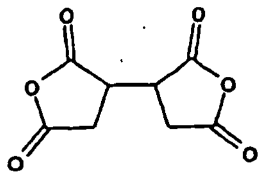

(II)

,

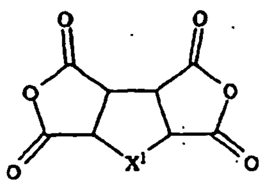

(III)

,

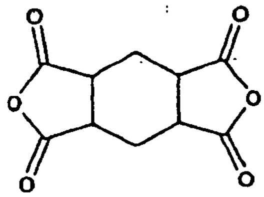

(IV)

,

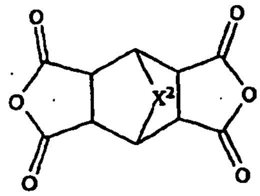

(V)

,

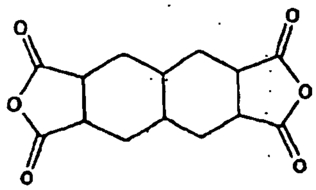

(VI)

,

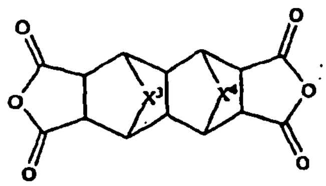

(VII)

,

wherein $X^1$ represents O, S, $CH_2$, $C(CH_3)_2$, or $C(CF_3)_2$;
$X^2$ represents O, S, or $CH_2$; and
$X^3$ and $X^4$ each independently represent O, S, or $CH_2$.

3. The resin according to claim 1, which has a transmittance for an incident light having a wavelength of 400 nm of 95% or more.

4. An optical semiconductor device comprising the resin according to claim 1 and an optical semiconductor element encapsulated with the resin.

5. The optical semiconductor device according to claim 4, which is a light-emitting diode device.

**Patentansprüche**

1. Harz zur Einkapselung eines optischen Halbleiterelements umfassend ein Polyimid, welches durch eine Imidierung einer Polyimidvorstufe erhalten wird, die durch eine Polykondensation eines aliphatischen Säuredianhydrids mit einer aliphatischen Diaminverbindung erhalten wird, die ausgewählt ist aus der Gruppe bestehend aus den Verbindungen, die durch die folgenden Formeln (X) bis (XI) wiedergegeben sind:

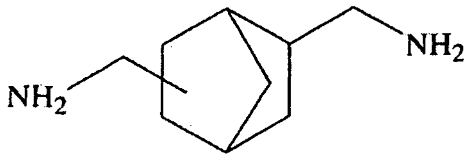

(X)

,

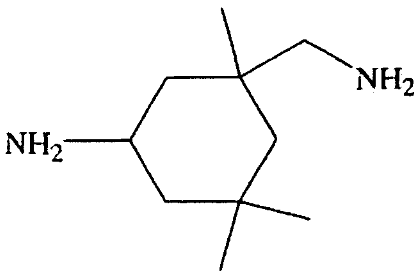

(XI)

.

2. Harz nach Anspruch 1, wobei das aliphatische Säuredianhydrid wenigstens ein Bestandteil ausgewählt aus der Gruppe bestehend aus den Tetracarbonsäuredianhydriden ist, die durch die folgenden Formeln (I) bis (VII) wiedergegeben sind:

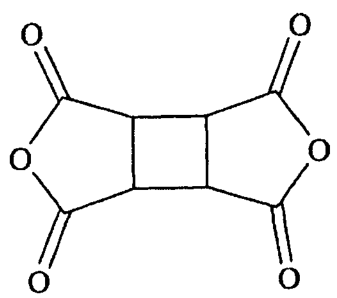

(I)

,

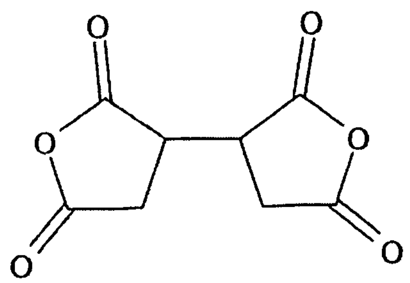

(II)

,

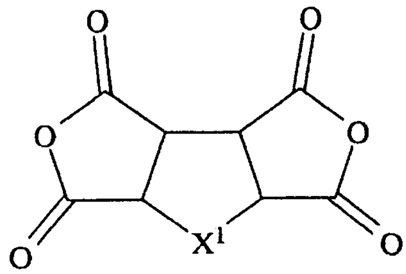

(III)

,

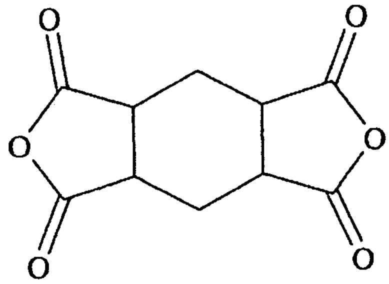

(IV)

,

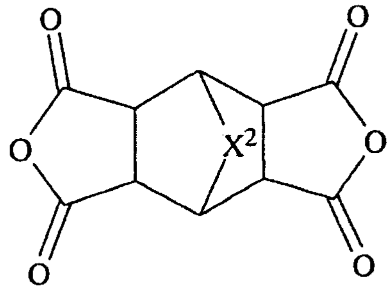

(V)

,

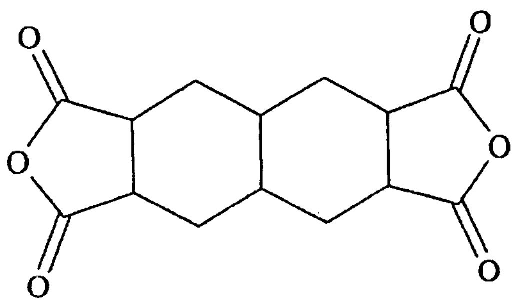

(VI)

,

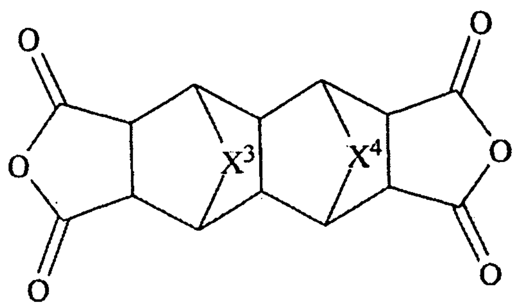

(VII)

,

wobei $X^1$ O, S, $CH_2$, $C(CH_3)_2$ oder $C(CF_3)_2$ bedeutet;
$X^2$ O, S oder $CH_2$ bedeutet; und
$X^3$ und $X^4$ jeweils unabhängig O, S oder $CH_2$ bedeuten.

3. Harz nach Anspruch 1, welches eine Durchlässigkeit für ein einfallendes Licht mit einer Wellenlänge von 400 nm von 95 % oder mehr aufweist.

4. Optische Halbleitervorrichtung umfassend das Harz nach Anspruch 1 und ein mit dem Harz eingekapseltes optisches Halbleiterelement.

5. Optische Halbleitervorrichtung nach Anspruch 4, welche eine lichtemittierende Diodenvorrichtung ist.

**Revendications**

1. Résine pour encapsulation d'éléments semiconducteurs optiques comprenant un polyimide qui est obtenu par une imidation d'un précurseur de polyimide obtenu par une polycondensation d'un dianhydride d'acide aliphatique avec un composé diamine aliphatique choisi dans le groupe consistant en les composés représentés par les formules (X) à (XI) suivantes :

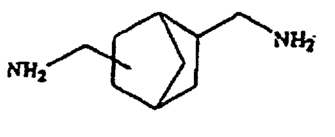

(X)

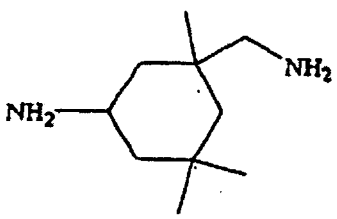

(XI).

2. Résine selon la revendication 1 où le dianhydride d'acide aliphatique est au moins un membre choisi dans le groupe consistant en les dianhydrides d'acides tétracarboxyliques représentés par les formules (I) à (VII) suivantes :

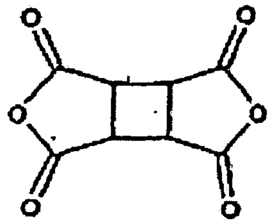

(I)

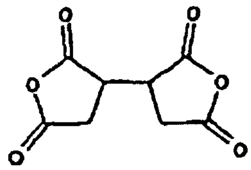

(II)

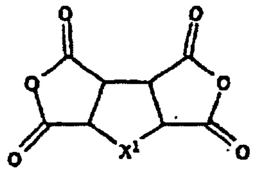

(III)

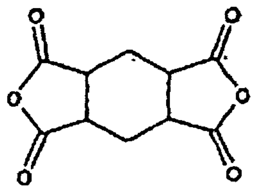

(IV)

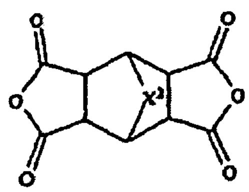

(V)

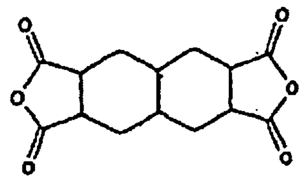

(VI)

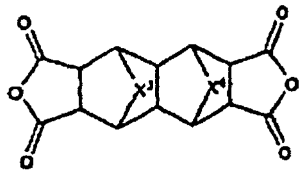

(VII)

où $X^1$ représente O, S, $CH_2$, $C(CH_3)_2$ ou $C(CF_3)_2$ ;
$X^2$ représente O, S ou $CH_2$ ; et
$X^3$ et $X^4$ représentent chacun indépendamment O, S ou $CH_2$.

**3.** Résine selon la revendication 1 qui a un facteur de transmission pour une lumière incidente ayant une longueur d'onde de 400 nm de 95 % ou plus.

**4.** Dispositif semiconducteur optique comprenant la résine selon la revendication 1 et un élément semiconducteur optique encapsulé avec la résine.

**5.** Dispositif semiconducteur optique selon la revendication 4 qui est un dispositif de type diode électroluminescente.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 7309927 A
- JP 2006274249 A
- JP 63007657 A
- JP 2001102500 A
- JP 2002322275 A
- EP 1146063 A
- US 6047098 A
- EP 1329769 A
- US 20040266979 A
- EP 0323644 A
- EP 1431822 A
- EP 0311374 A
- EP 0424940 A
- EP 2009058 A


### Non-patent literature cited in the description


- **Q.Li et al.** Absorption Fluorescence and Thermal Properties of Transparent Polyimides Based on Cyclobutanetetracarboxylic Dianhydride. *Polymer Journal,* 01 January 1998, vol. 30 (10), 805-812